(19) **Europäisches Patentamt / European Patent Office / Office européen des brevets**

(11) **EP 4 730 657 A1**

(12) **EUROPEAN PATENT APPLICATION**

(43) Date of publication:
22.04.2026 Bulletin 2026/17

(21) Application number: 24206837.7

(22) Date of filing: 16.10.2024

(51) International Patent Classification (IPC):
$H03M\ 1/12^{(2006.01)}$  $H03M\ 1/48^{(2006.01)}$
$H03M\ 1/80^{(2006.01)}$

(52) Cooperative Patent Classification (CPC):
H03M 1/48; H03M 1/1275; H03M 1/46; H03M 1/804

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: Imec VZW
3001 Leuven (BE)

(72) Inventors:
• **Yang, Xiaolin**
  3000 Leuven (BE)
• **Xing, Xiaonan**
  3001 Heverlee (BE)
• **Sawigun, Chutham**
  3001 Leuven (BE)
• **Mora Lopez, Carolina**
  3001 Heverlee (BE)

(74) Representative: **Roth, Sebastian**
Mitscherlich PartmbB
Karlstraße 7
80333 München (DE)

(54) **A REFERENCE-LESS LEVEL-CROSSING ADC WITH A BUMP-BASED ADAPTIVE-BIAS COMPARATOR**

(57)   This disclosure relates to an ADC circuit and a comparator circuit for a neural interface. The ADC circuit can include the comparator circuit. The comparator circuit comprises a comparator to receive a first and a second signal, and internally amplify the first and the second signal. A bump bias circuit of the comparator circuit receives the amplified first and second signal, and causes the comparator to operate at a higher power level when a difference between the amplified first and second signal is smaller, and at a lower power level when the difference between the amplified first and second signal is larger. The ADC circuit comprises two comparator circuits connected to a first and second switching circuit. A control circuit of the ADC circuit can set a capacitor state of first capacitor pairs of the first switching circuit, and a capacitor state of second capacitors pairs of the second switching circuit, based on outputs of the first and second comparator circuit.

**FIG.6**

**Description**

TECHNICAL FIELD

The present disclosure relates to comparators and analog-to-digital converters (ADCs), for example, suitable for a neural interface. A level-crossing (LC) based ADC circuit for a neural interface is presented. The ADC circuit may include at least one comparator circuit that has a bump bias circuit. Further, a method of operating the LC based ADC circuit is provided.

BACKGROUND

A large-scale neural interface is a system designed to facilitate extensive recordings from hundreds, or even thousands, of individual neurons simultaneously. This technology provides a means for neuroscience to better understand the inner workings of the brain.

An ADC is indispensable in such systems, and is used to periodically sample and convert neural signals for data transmission and post-processing. The ADC needs to have a sampling rate of tens of thousands of samples per second for each recording site. Hence, with increased recording density, data transmission or processing becomes a critical challenge. One promising approach is to facilitate a LC ADC, which converts a neural signal only when a specific neural event, such as a spike, happens. Unlike a traditional continuous-sampling ADC, which can generate massive amounts of data even when the neural activity is sparse, the LC ADC operates on a "sample-on-change" principle. It only records data when there is a meaningful change in the signal, hence, it reduces the overall data volume.

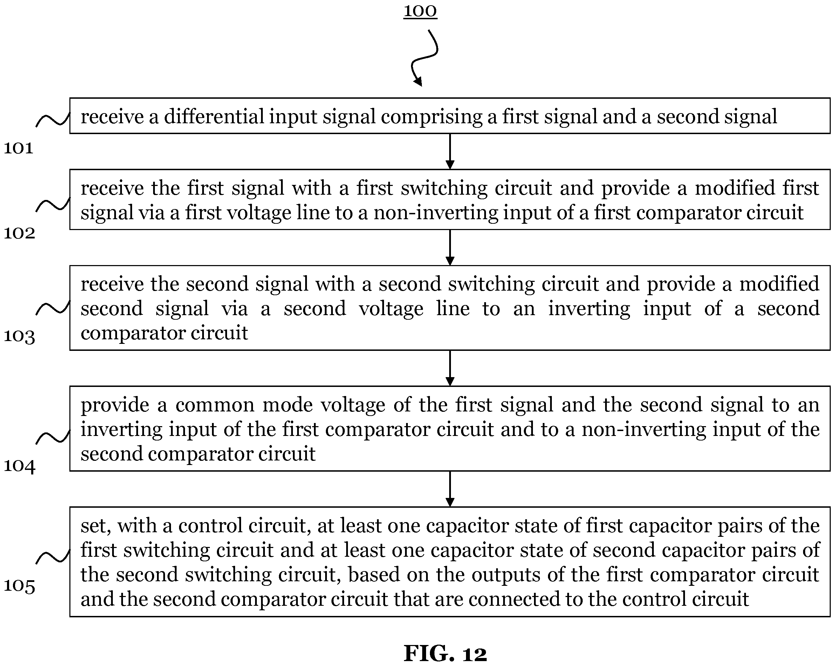

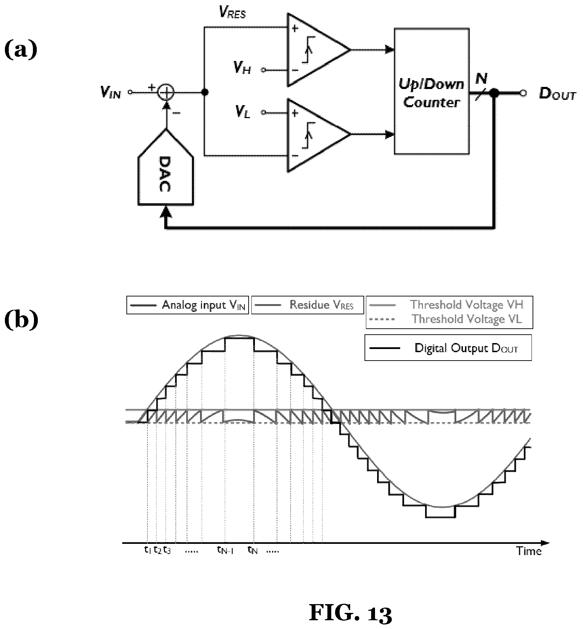

In particular, to achieve relatively low power consumption, a fixed-threshold-window LC ADC is conventionally used. As shown in Figure 12(a), such a LC ADC continuously tracks an input signal through a fixed threshold window, which is created by two voltages $V_H$ (high) and $V_L$ (low). An input representation of the quantized digital output Dour is fed back through a digital-to-analog converter (DAC), and subtracted from the analog input $V_{IN}$. The residue voltage $V_{RES}$ is the quantization error, which is then compared against two voltage thresholds $V_H$ and $V_L$ by upper or lower zero-crossing detectors (ZCD). When $V_{RES}$ exceeds this comparison interval, the corresponding ZCD triggers an update, and the up-down counter either increments or decrements, causing the DAC output to shift up or down by a voltage value $V_{th}$ (wherein it is assumed that $V_{th}$ is equal to $V_H$-$V_L$), so that the residue $V_{RES}$ is again maintained within the comparison interval (between $V_H$ and $V_L$). Therefore, the LC ADC generates a digital output only when a crossing or an event happens, which leads to a non-uniform sampling and conversion. FIG. 13(b) shows an example of a waveform (digital output $D_{OUT}$) of the LC ADC of FIG. 13(a) in comparison with the analog input $V_{IN}$.

The voltage thresholds created by $V_H$ and $V_L$ are crucial to the performance of the LC ADC. An extra voltage generator is, however, needed to generate these voltages. Moreover, a mismatch between $V_H$-$V_L$ and $V_{th}$ will degrade the performance of the LC ADC. An extra on-chip circuit or an off-chip fine trimmer may be used to generate the voltages $V_H$ or $V_L$ to eliminate this. However, both cause hardware complexity. Moreover, to continuously monitor the change of the residue voltage $V_{RES}$, the comparators should be always-on, so that the comparators consume a static bias current for a fast decision once a crossing happens. This results overall in high power consumption even if there is no event.

SUMMARY

In view of the above, an objective of this disclosure is to provide an ADC circuit for a neural interface, which is able to operate based on LC. The ADC circuit should require no additional voltage generators, and should be of lower hardware complexity than at least a conventional LC ADC for a neural interface. Another objective is to equip the LC ADC circuit with at least one comparator circuit that has a low power consumption.

These and other objectives are achieved by the solutions of this disclosure described in the independent claims. Advantageous implementations are described in the dependent claims.

A first aspect of this disclosure provides an ADC circuit for a neural interface, wherein the ADC circuit is configured to receive a differential input signal comprising a first signal and a second signal, and wherein the ADC circuit comprises a first comparator circuit and a second comparator circuit, wherein an inverting input of the first comparator circuit and a non-inverting input of the second comparator circuit are connected to a common mode voltage of the first signal and the second signal; a first switching circuit configured to receive the first signal and to output a modified first signal via a first voltage line to a non-inverting input of the first comparator circuit; a second switching circuit configured to receive the second signal as an input and to provide a modified second signal via a second voltage line to an inverting input of the second comparator circuit; and a control circuit, wherein an output of each comparator circuit is connected as input to the control circuit; wherein the first switching circuit comprises a plurality of first capacitor pairs, and the second switching circuit comprises a plurality of second capacitor pairs, wherein the first and the second capacitor pairs are respectively arranged one after the other along the first voltage line and the second voltage line, and are respectively connected with a common node to the first voltage line and the second voltage line; wherein the control circuit is configured to set at least one capacitor state of the first capacitor pairs and at least one capacitor state of the second capacitors pairs based on the outputs of the first comparator circuit and the second comparator circuit.

To eliminate usage of voltage thresholds - as required in a conventional LC ADC - a pre-switching concept is introduced, namely by adding the first and the second switching circuit. In particular, these switching circuits may deviate the input signals by a certain voltage value, under the control of the control circuit. The control circuit may be a control DAC. Since no voltage thresholds are needed, additional voltage generators can also be omitted. Further, also an extra on-chip circuit and/or an off-chip fine trimmer for such voltage values are not necessary. Therefore, a hardware complexity of the LC ADC circuit is low.

As will be described in more detail below, a comparator circuit in this disclosure - like the first comparator circuit or the second comparator circuit - may consist of a comparator, or may comprise a comparator and additional circuitry connected to the comparator.

The differential input signal maybe a differential voltage signal, i.e., the first signal and the second signal are voltage signals, e.g., of varying voltage value. Also the modified signals and the internally amplified signals may be voltage signals.

In an implementation of the ADC circuit, the control circuit is configured to initially set each capacitor state to a default value.

In an implementation of the ADC circuit the control circuit is configured to change at least one capacitor state of the first capacitor pairs, such that a predetermined voltage value is subtracted from the modified first signal when the second signal is smaller than the common mode voltage, and such that the predetermined voltage value is added to the modified first signal when the second signal is larger than the common mode voltage.

In an implementation of the ADC circuit, when the output of the first comparator circuit switches "up" from a low state to a high state, while the output of the second comparator circuit stays at a high state, the control circuit is configured to change at least one capacitor state of the first capacitor pairs such that the predetermined voltage value is subtracted from the modified first signal, and to change at least one capacitor state of the second capacitor pair such that the predetermined voltage value is added to the modified second signal; and when the output of the first comparator circuit switches "down" from a high state to a low state, while the output of the second comparator circuit stays at a low state, the control circuit is configured to change at least one capacitor state of the first capacitor pairs such that the predetermined voltage value is added to the modified first signal, and to change at least one capacitor state of the second capacitor pairs such that the predetermined voltage value is subtracted from the modified second signal.

In an implementation of the ADC circuit, when the output of the second comparator circuit switches "down" from a high state to a low state, the control circuit is configured to change at least one capacitor state of the first capacitor pairs such that twice the predetermined voltage value is added to the modified first signal; and when the output of the second comparator circuit switches "up" from a low state to a high state, the control circuit is configured to change at least one capacitor state of the first capacitor pairs such that twice the predetermined voltage value is subtracted from the modified first signal.

In an implementation of the ADC circuit, the ADC circuit further comprises an up-down counter, which is configured to receive from the control circuit an output signal and an indication of "up" or "down" switch of a comparator circuit output, and is configured to output a cumulated signal based on the output signal and indication received from the control circuit.

In an implementation of the ADC circuit, the first comparator circuit comprises: a first comparator configured to internally amplify the modified first signal and the common mode voltage, respectively; a first bump bias circuit configured to receive the amplified modified first signal and the amplified common mode voltage; wherein the first bump bias circuit is further configured to cause the first comparator to operate at a higher power level when a difference between the amplified modified first signal and the amplified common mode voltage is smaller, and operate at a lower power level when the difference between the amplified modified first signal and the amplified common mode voltage is larger.

In an implementation of the ADC circuit, the second comparator circuit comprises: a second comparator configured to internally amplify the modified second signal and the common mode voltage, respectively; a second bump bias circuit configured to receive the amplified modified second signal and the amplified common mode voltage; wherein the second bump bias circuit is further configured to cause the second comparator to operate at a higher power level when a difference between the amplified modified second signal and the amplified common mode voltage is smaller, and operate at a lower power level when the difference between the amplified modified second signal and the amplified common mode voltage is larger.

For instance, both the first comparator circuit and the second comparator circuit may be integrated with a respective bump bias circuit, as described above. In this case, the modified first signal and the common mode voltage are a first differential input signal for the first comparator circuit, whereas the common mode voltage and the modified second signal are a second differential input signal for the second comparator circuit. Notably, the non-inverting input and inverting input of a comparator circuit relate to a non-inverting input and inverting input of a comparator of said comparator circuit.

The first comparator circuit will operate in the higher power mode when the difference between the amplified modified first signal and the amplified common mode voltage is smaller, and the second comparator circuit will operate in the higher power mode when the difference between the amplified modified second signal and the amplified common mode voltage is smaller.

A comparator circuit having the bump bias circuit can operate with a low power consumption. In particular, to achieve a reduced power consumption compared to a conventional comparator, the bump bias circuit is integrated with the comparator of the comparator circuit (the comparator may be a conventional comparator, except that it is connected to the bump bias circuit in the manner described). The bump bias circuit is used to monitor the amplified versions of the input signals, which may be voltage signals (here the amplified modified first or second signal and the amplified common mode voltage). When the amplified signals are closer together, the bump bias circuit will operate to set the comparator to the higher power mode. Conversely, when the amplified signals are less close together, i.e. more different from each other, the bump bias circuit tends to set the comparator into the lower power mode, which saves power. The current consumption is thus significantly lower than for a conventional constant bias comparator.

In an implementation of the ADC circuit, the first and/or second bump bias circuit is configured to provide a larger supply current to respectively the first or second comparator when the difference between respectively the amplified modified first or second signal and the common mode voltage is smaller; and provide a smaller supply current to respectively the first or second comparator when the difference between respectively the amplified modified first or second signal and the amplified common mode voltage is larger.

The first bump bias circuit relates to the first comparator and the amplified modified first signal, while the second bump bias circuit relates to the second comparator and the amplified modified second signal.

The bump bias circuit may comprise circuitry that receives the respective internally amplified signals as input, and provides the supply current in dependence of the difference between said amplified signals as output. This may be achieved with a variety of transistors and/or transistor pairs, but is not limited to that example. For example, the supply current may be mirrored back through a current mirror to the comparator. The larger supply current maintains or transitions the comparator into the higher power mode, while the lower supply current maintains or transitions the comparator into the lower power mode, to significantly save power. In this disclosure, the comparator's power mode may accordingly depend on the supply current provided to the comparator.

In an implementation of the ADC circuit, the first and/or second bump bias circuit is configured to provide a continuously increasing supply current to respectively the first or second comparator when a difference between respectively the amplified modified first or modified signal and the amplified common mode voltage continuously decreases.

In an implementation of the ADC circuit, the first and/or second bump bias circuit respectively comprises a first transistor pair comprising a first transistor a second transistor, a second transistor pair comprising a third transistor and a fourth transistor, wherein a source of the first transistor is connected to a drain of the second transistor; wherein a source of the third transistor is connected to a drain of the fourth transistor; wherein a source of the second transistor and a source of the fourth transistor are connected to ground; wherein a drain of the first transistor and a drain of the third transistor are connected to a common node, to which also a current output transistor is connected; wherein the amplified modified first or second signal, respectively, is connected to a gate of the first transistor and a gate of the fourth transistor; wherein the common mode voltage is connected to a gate of the second transistor and a gate of the third transistor; and wherein the current output transistor is configured to output a larger supply current to respectively the first or second comparator when the difference between respectively the amplified modified first or second signal and the amplified common mode voltage is smaller, and output a smaller supply current to respectively the first or second comparator when the difference between respectively the amplified modified first or second signal and the amplified common mode voltage is larger.

This provides an example of the above-mentioned circuitry of the bump bias circuit. The exemplary bump bias circuit with the various transistors can be integrated with the (transistors of the) comparator, maintaining a low hardware complexity. Again, the first bump bias circuit relates to the first comparator and the amplified modified first signal, while the second bump bias circuit relates to the second comparator and the amplified modified second signal.

In an implementation of the ADC circuit, a source of the current output transistor is connected to a supply voltage; a drain of the current output transistor is connected to the common node; and a gate of the current output transistor is connected to the drain of the current output transistor and to the comparator.

In an implementation of the ADC circuit, the gate of the current output transistor is connected to a gate of a current input transistor of respectively the first or second comparator; wherein the current output transistor and the current input transistor form a current mirror.

In this way, the supply current is mirrored back through the current mirror to the comparator, and can set or transition the comparator into a higher power mode or lower power mode, respectively.

In an implementation of the ADC circuit, wherein the first and/or second comparator circuit is configured to perform an auto-zeroing operation to calibrate the first and/or second bump bias circuit, such that the first and/or second bump bias circuit is configured to cause respectively the first or second comparator to operate at a maximum power level when the amplified modified first or second signal is equal to the amplified common mode voltage.

A mismatch across the transistors of the bump bias circuit may introduce an offset, which may shift the zero-crossing point of the feedback signal (e.g., supply current) to the comparator to an offset voltage. To mitigate this effect, the offset calibration - i.e., the auto-zeroing operation - may be performed before the comparator circuit's normal operation. In this way, for example, it may be achieved that the largest supply current is fed back to the comparator, if the amplified input signals to the comparator are equal.

The first comparator circuit relates to the first bump bias circuit, the first comparator, and the amplified modified first signal, while the second comparator circuit relates to the second bump bias circuit, the second comparator, and the amplified modified second signal

A second aspect of this disclosure provides a method of operating an ADC circuit for a neural interface, wherein the ADC circuit comprises a first comparator circuit, a second comparator circuit, a first switching circuit, a second switching circuit, and a control circuit, and wherein the method comprises: receiving a differential input signal comprising a first signal and a second signal; receiving the first signal with the first switching circuit and providing a modified first signal via a first voltage line to a non-inverting input of the first comparator circuit; receiving the second signal with the second switching circuit and providing a modified second signal via a second voltage line to an inverting input of the second comparator circuit; providing a common mode voltage of the first signal and the second signal to an inverting input of the first comparator circuit and to a non-inverting input of the second comparator circuit; setting, by the control circuit, at least one capacitor state of first capacitor pairs of the first switching circuit and at least one capacitor state of second capacitors pairs of the second switching circuit based on the outputs of the first comparator circuit and the second comparator circuit connected to the control circuit; wherein the first and the second capacitor pairs are respectively arranged one after the other along the first voltage line and the second voltage line, and are respectively connected with a common node to the first voltage line and the second voltage line.

The method of the second aspect may have implementations that correspond to the implementations of the ADC circuit of the first aspect. The method of the second aspect and its implementations achieve the same advantages a described above with respect to the ADC circuit of the first aspect and its implementation.

BRIEF DESCRIPTION OF THE DRAWINGS

The above described aspects and implementations are explained in the following description of embodiments with respect to the enclosed drawings:

FIG. 1       shows a comparator circuit according to this disclosure.

FIG. 2       shows an exemplary diagram of a comparator circuit according to this disclosure.

FIG. 3       shows a schematic implementation of an exemplary comparator circuit according to this disclosure.

FIG. 4       shows simulation results of respectively an exemplary comparator circuit according to this disclosure and of a conventional comparator.

FIG. 5       illustrates an exemplary comparator offset calibration method.

FIG. 6       shows an ADC circuit according to this disclosure.

FIG. 7       illustrates state machines of main-switching and pre-switching control in an exemplary ADC circuit according to this disclosure.

FIG. 8       shows a neural interface including an array of electrodes, a plurality of recording channels, and an ADC circuit according to this disclosure.

FIG. 9       illustrates transient waveforms of the exemplary ADC circuit according to this disclosure.

FIG. 10      illustrates an exemplary common-mode voltage generation method for an ADC circuit according to this disclosure.

FIG. 11      shows an exemplary M-bit up-down counter of the ADC circuit according to this disclosure.

FIG. 12      shows a method of operating a comparator circuit according to this disclosure.

FIG. 13    shows a conventional LC ADC and some waveforms thereof.

DETAILED DESCRIPTION OF EMBODIMENTS

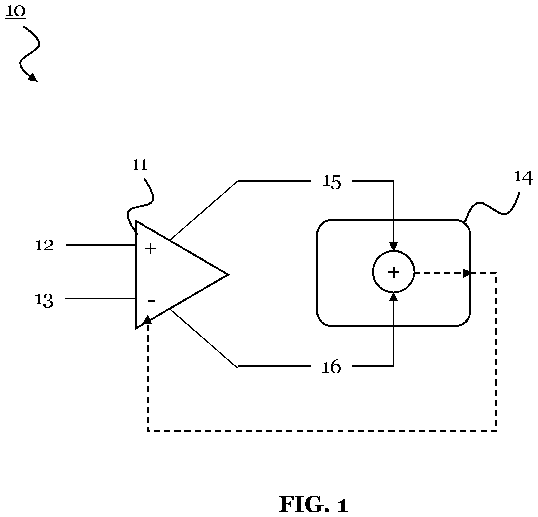

FIG. 1 shows a comparator circuit 10 according to this disclosure. The comparator circuit 10 comprises a comparator 11, which may be a conventional comparator having an inverting and a non-inverting input. The comparator circuit 10 further comprises a bump bias circuit 14. The comparator circuit 10 may thus be referred to as a bump-based adaptive-bias comparator.

The comparator 11 is configured to receive a differential input signal, which comprises a first signal 12 and a second signal 13, for instance, two different voltage signals. At least one of these signals 12, 13 may be time-varying. The comparator 11 is configured to internally amplify the first signal 12 and the second signal 13, respectively, thereby producing an amplified first signal 15 and an amplified second signal 16.

The bump bias circuit 14 is connected to the comparator 11, in particular, such that is configured to receive the amplified first signal 15 and the amplified second signal 16, respectively, from the comparator 11. The bump bias circuit 14 may be configured to determine a difference between the amplified first signal 15 and the amplified second signal 16, for instance, by summing the amplified first signal 15 which is associated with the non-inverting input of the comparator 11 and the amplified second signal 16 which is associated with the inverting input of the comparator 11.

The bump bias 14 circuit is further configured to cause the comparator 11 to operate at a higher power level when a difference between the amplified first signal 15 and the amplified second signal 16 is smaller, and to operate at a lower power level when the difference between the amplified first signal 15 and the amplified second signal 16 is larger. This may be done by providing a feedback signal to the comparator 11 (indicated by dashed arrow), which is dependent on the difference between the amplified first and second signal 15, 16. For instance, the feedback signal may be a supply current. Since the comparator 11 is in this way not always used in the higher power mode, but sometimes in the lower power mode, its power consumption can be lowered. The comparator 11 may only operate in the higher power mode when needed, for instance, in the case of an event expressed by the difference of the amplified signals 15, 16 becoming smaller.

In other words, to reduce the power consumption compared to a conventional comparator, the bump bias circuit 14 is integrated with the comparator 11. The bump bias circuit 14 is used to monitor the intermediate outputs, i.e. the amplified first and second signal 15, 16, which are the amplified versions of the input signals 12, 13 to the comparator 11.

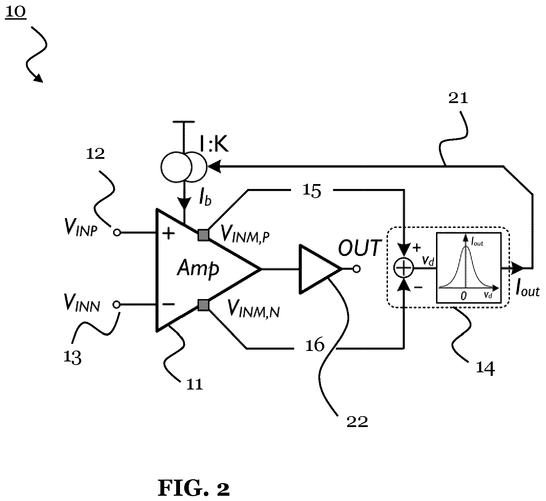

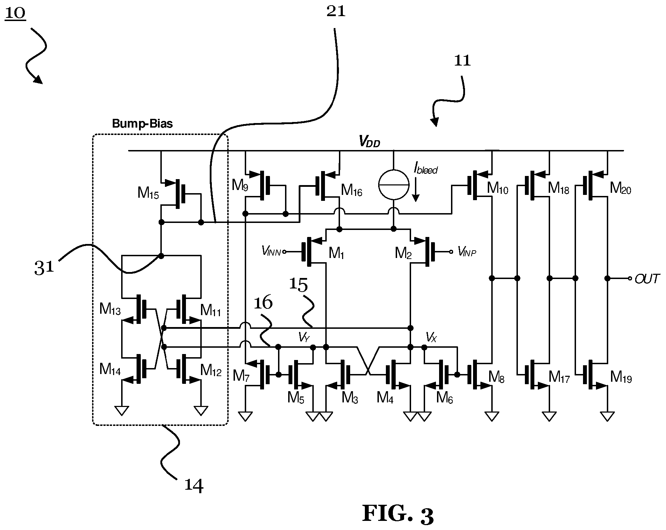

FIG. 2 shows an exemplary diagram of a comparator circuit 10 according to this disclosure, and FIG. 3 shows a schematic implementation of an exemplary comparator circuit 10 according to this disclosure. The comparator circuits 10 of FIG. 2 and 3 respectively base on the comparator circuit 10 of FIG. 1. Same elements are labelled with the same reference signs and may be implemented likewise.

As shown in FIG. 2, the bump bias circuit 14 is in this example configured to provide a supply current as feedback signal to the comparator 11. In particular, the bump bias circuit 14 is configured to provide a larger supply current 21 to the comparator 11 when the difference between the amplified first signal 15 and the amplified second signal 16 is smaller, and is configured to provide a smaller supply current 21 to the comparator 11 when the difference between the amplified first signal 15 and the amplified second signal 16 is larger. Given that the bump bias circuit 14 is calibrated, it may provide the largest supply current 21 to the comparator 11, if the amplified first signal 15 and the amplified second signal 16 are equal.

When the amplified signals 15 and 16 are closer together, the larger supply current will cause the comparator 11 to operate in the higher power mode, e.g., it may transition the comparator 11 into the higher power mode. Conversely, when the amplified signals 15 and 16 differ more from each other, the lower supply current will cause the comparator 11 to operate in the lower power mode, e.g., it may transition the comparator 11 to the lower power mode, in order to significantly save current and power.

Notably, the comparator 11 shown in FIG. 2 may, of course, also proved an output signal 22, like a conventional comparator without bump bias circuit 14.

As shown in FIG. 3, the bump bias circuit 14 may include the four transistors $M_{11}$ to $M_{14}$ and an additional current output transistor $M_{15}$. The transistors $M_{11}$ to $M_{14}$ are incorporated to monitor the intermediate output (amplified signals 15, 16; labelled $V_X$ and $V_Y$) of the comparator 11. $V_X$ and $V_Y$ present the amplified versions of the input signals $V_{INP}$ and $V_{INN}$ shown in FIG. 2. The amplification maybe related to a gain of $g_{m1,2}/(g_{m5,6}\text{-}g_{m3,4})$. When the amplified signals 15 and 16 related to the input signals 12 and 13 are close together, the larger supply current 21 is mirrored back through a current mirror to the comparator 11. The current mirror may be formed by $M_{15}$ and a current input transistor $M_{16}$ of the comparator 11. The larger supply current 21 sets the comparator 11 to the higher power mode. The gate of $M_{15}$ is thereby connected to the gate of $M_{16}$. When the amplified signals 15 and 16 related to the input signals 12 and 13 are more different from each other, the smaller supply current sets the comparator 11 to the lower power mode.

In more detail, the first transistor $M_{11}$ and the second transistor $M_{12}$ form a first transistor pair, and the third transistor $M_{13}$ and the fourth transistor $M_{14}$ form a second transistor pair. A source of $M_{11}$ is connected to a drain of $M_{12}$, and a source of $M_{13}$ is connected to a drain of $M_{14}$. Further, a source of $M_{12}$ and a source of $M_{14}$ are connected to ground. A drain of $M_{11}$ and a drain of $M_{13}$ are connected to a common node 31, to which also the current output transistor $M_{15}$ is connected.

In particular, a source of $M_{15}$ is connected to a supply voltage $V_{DD}$, a drain of $M_{15}$ is connected to the common node 31, and a gate of $M_{15}$ is connected to the drain of $M_{15}$ and to the comparator 11.

The amplified first signal 15 ($V_X$) is connected to a gate of $M_{11}$ and to a gate of $M_{14}$, and the amplified second signal 16 ($V_Y$) is connected to a gate of $M_{12}$ and to a gate of $M_{13}$. The current output transistor $M_{15}$ is configured to output a larger supply current 21 to the comparator 11 when the difference between the amplified first signal 15 and the amplified second signal 16 is smaller, and to output a smaller supply current 21 to the comparator 11 when the difference between the amplified first signal 15 and the amplified second signal 16 is larger.

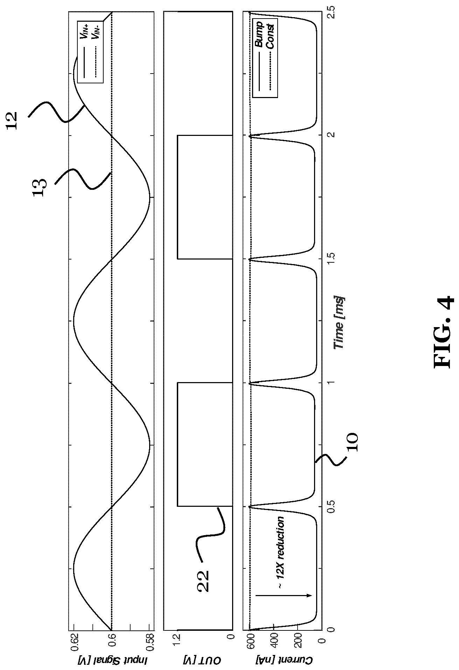

FIG. 4 shows simulation results of the comparator circuit 10, in particular, shows exemplary input (voltage) signals 12 and 13 in the upper diagram, shows an output signal 22 of the comparator in the middle diagram, and shows a current consumption of the comparator 11 - particularly, compared to a conventional constant bias comparator - in the lower diagram. It can be seen that the current consumption, and thus the power consumption, of the comparator 11 is reduced significantly, up to a factor of 12 compared to the conventional comparator.

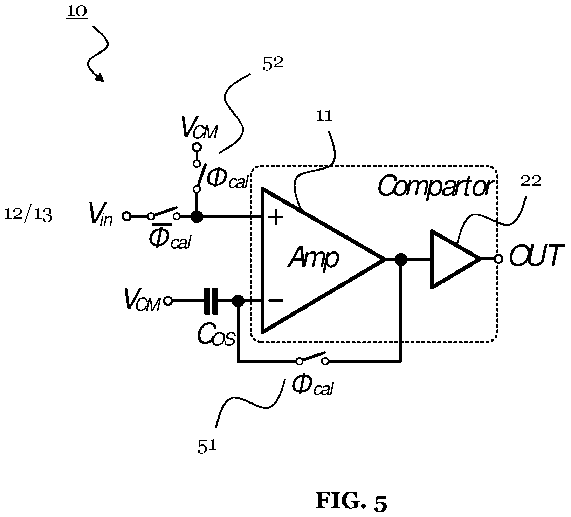

Notably, a mismatch across the transistors of the bump bias circuit 14 could introduce an offset, which could shift the zero-crossing point to an offset voltage Vos. That is, the largest supply current 21 would not be provided for exactly the case when the first amplified signal 15 and the second amplified signal 16 are equal. However, to mitigate this effect, an offset calibration may be performed with the comparator circuit 10, before entering its normal ADC operations. A widely used auto-zeroing technique can be used, as shown in FIG. 5. The auto-zeroing technique may guarantee that largest supply current 21 is provided for the case when the first amplified signal 15 and the second amplified signal 16 are equal.

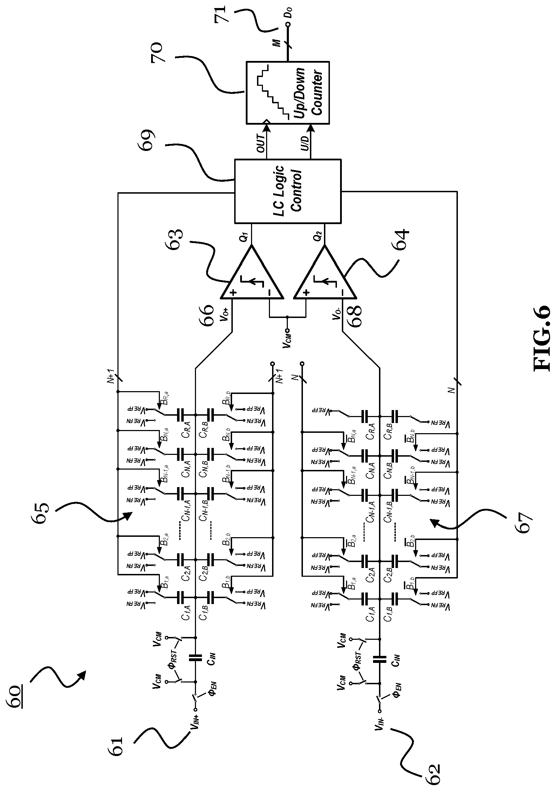

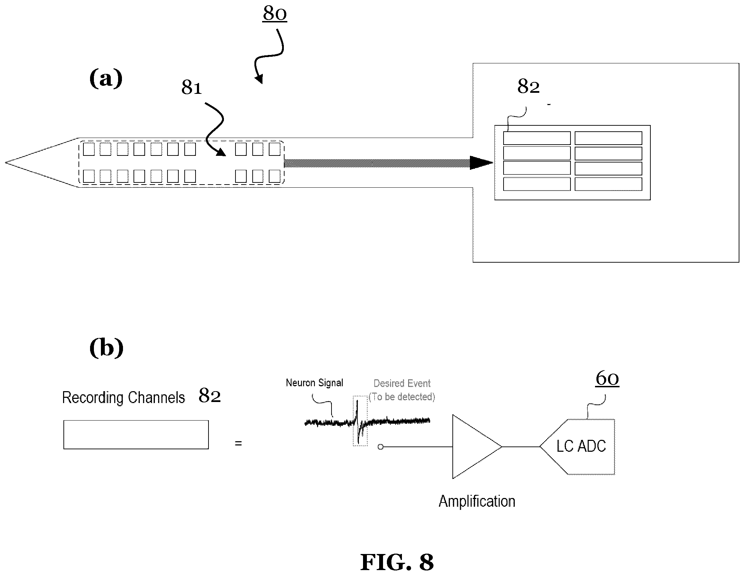

FIG. 6 shows an ADC circuit 60 according to this disclosure. The ADC circuit 60 may make use of the comparator circuit 10 presented above with respect to FIG. 1 or FIG. 2. That is, a beneficial application scenario for the comparator circuit 10 is presented. The ADC circuit 60 may be used for a neural interface 80, as shown in FIG. 8. In particular, in the neural interface 80, the ADC circuit 60 may periodically sample and convert neural signals, for example, for data transmission and post-processing.

FIG. 8(a) shows that the neural interface 80 may comprise a needle-like device, which may be equipped with an array of electrodes 81 connected to a plurality of recording channels 82. The use of the needle-like device may involve implanting the electrodes 82 to record or stimulate brain activity. The recording channels 82 may detect electrical signals from the neurons of the brain (i.e., the neural signals). Each recording channel 82 may record a particular neural signal, as shown in FIG. 8(b). An event in the neural signal may be detected using the LC based ADC circuit 60 of FIG. 6.

The ADC circuit 60 may accordingly replace a conventional LC ADC, for instance, in a neural interface 80. The ADC circuit 60 comprises a first switching circuit 65 and a second switching circuit 67, which may also be called pre-switching circuits, which are arranged before a first comparator circuit 63 and a second comparator circuit 64 with relation to input and output. The ADC circuit 60 may thereby be provide with a built-in threshold-window switching mechanism. Either one or both of the first comparator circuit 63 and the second comparator circuit 64 may be implemented by a comparator circuit 10 as described with respect to FIG. 1 or FIG. 2, i.e., it may include a bump bias circuit 14. Alternatively, either one or both of the first comparator circuit 63 and the second comparator circuit 64 may be implemented by a simple comparator, in which case the respective comparator circuit 63, 64 does not comprise a bump bias circuit 14. In an example, the first and the second comparator circuit 63, 64 is respectively a comparator circuit 10 with a bump bias circuit 14. In another example, the first comparator circuit 63 is a comparator circuit 10 with a bump bias circuit 14, while the second comparator circuit 64 is a comparator without a bump bias circuit 14. In another example, the second comparator circuit 64 is a comparator circuit 10 with a bump bias circuit 14, while the first comparator circuit 63 is a comparator without a bump bias circuit 14. In another example, the first comparator circuit 63 and the second comparator circuit 64 is respectively a comparator without a bump bias circuit 14.

The first switching circuit 65 and the second switching circuit 67 are used to implement a pre-switching concept in the ADC circuit 60, in order to eliminate the need of voltage thresholds like in a conventional LC ADC.

The first switching circuit 65 is configured to receive a first signal 61, and to output a modified first signal 66 via a first voltage line to a non-inverting input of the first comparator circuit 63. The second switching circuit 67 is configured to receive a second signal 62 as an input, and to provide a modified second signal 68 via a second voltage line to an inverting input of the second comparator circuit 64. An inverting input of the first comparator circuit 63 and a non-inverting input of the second comparator circuit 64 are connected to a common mode voltage VCM of the first signal 61 and the second signal 62.

If the first comparator circuit 63 and the second comparator circuit 64 are comparator circuits 10, i.e. are integrated with a respective bump bias circuit 14, as described above, then the differential input signal for the first comparator circuit 63 comprises the modified first signal 66 as the first signal 12, and comprises the common mode voltage as the second signal 13. The differential input signal for the second comparator circuit 64 comprises the modified second signal 68 as the second signal 13, and comprises the common mode voltage as the first signal 12.

The first switching circuit 65 comprises a plurality of first capacitor pairs, and the second switching circuit 67 comprises a plurality of second capacitor pairs ($C_{i,A}$, $C_{i,B}$), wherein the first and the second capacitor pairs are respectively arranged one after the other along the first voltage line and the second voltage line, and are respectively connected with a common node to the first voltage line and the second voltage line.

An output of each comparator circuit 63, 64 (corresponding to the output signal 22 shown in FIG. 2 if implemented as the comparator circuit 10) is connected as input to a control circuit 69. The control circuit 69 is configured to set at least one capacitor state of the first capacitor pairs and at least one capacitor state of the second capacitors pairs based on the outputs of the first comparator circuit 63 and the second comparator circuit 64.

The pre-switching concept may be implemented by deviating the first signal 61 and the second signal 62 by a certain predetermined voltage value, which may be controlled by the control circuit 69. For example, by changing at least one capacitor state of the first capacitor pairs, such that a predetermined voltage value is subtracted from the modified first signal 66 when the second signal 62 is smaller than the common mode voltage, and such that the predetermined voltage value is added to the modified first signal 68 when the second signal 62 is larger than the common mode voltage.

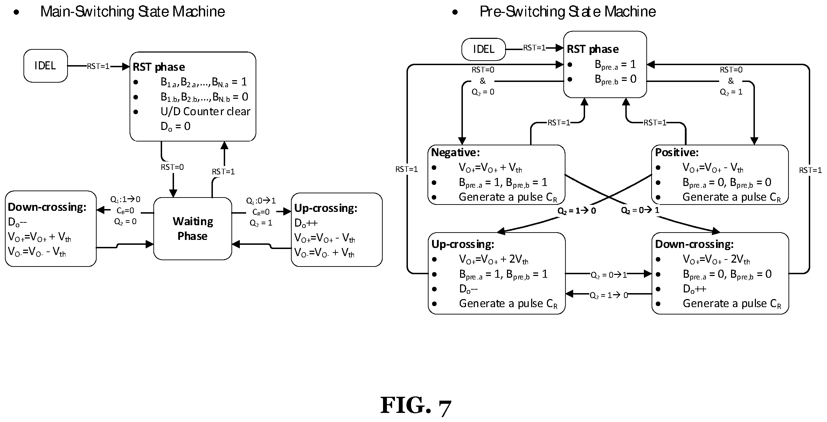

More exemplary details of the ADC circuit 60 are described in the following with reference to FIG. 6 and FIG. 7. For simplicity, it may be assumed that the input signals 61 and 62 ($V_{IN+}$ and $V_{IN-}$) are differential signals with the common-mode voltage $V_{CM}$. As shown in FIG. 6, the ADC circuit 60 may have an M-bit resolution with 2xN identical capacitors ($C_{i,A}$ and $C_{i,B}$, i = 1 ...N) at each switching circuit 65, 67, wherein $N = 2^{(M-1)}-1$. Extra two capacitors $C_{R,A}$ and $C_{R,B}$ may be added for an example of the pre-switching strategy at both switching circuits 65, 67. The input capacitor $C_{in}$ may be equal to the total capacitance of the control circuit 69.

A detailed procedure, which may be performed by the ADC circuit 60, is as follows with reference to FIG. 7, which shows a state machine of main-switching and pre-switching control in an exemplary ADC circuit 60, respectively.

1. At a reset phase, the ADC control logic 69 initiates to a default value where all $B_{1,a}$ ... $B_{N,a}$, $B_{pre,a}$ and $B_{1,b}$ ... $B_{N,b}$, $B_{pre,b}$ bits are set to *(N+1)'b11...11* and *(N+1)'b00...00,* respectively. Meanwhile, the differential voltage $V_{O+}$ and $V_{O-}$ at the top plate of the control circuit 69 are set to a common-mode voltage $V_{CM}$. Notably, any of $B_{1,a}$ ... $B_{N,a}$, $B_{pre,a}$ and $B_{1,b}$ ... $B_{N,b}$ when set to 1, is connected to $V_{REFN}$, and when set to O, is connected to $V_{REFP}$. The same holds for Br,a and Br,b, respectively.

2. After the reset phase, the second comparator circuit 64 will monitor the polarity of the voltage value of $V_{CM}-V_{O-}$. If the polarity is *positive ($V_{CM} > V_{O-}$)*, the bit $B_{pre,a}$ is changed from 1'b1 to 1'b0. Therefore, the certain value (predetermined voltage value) $V_{th}$ will be subtracted from Vo+, which equals:

$$V_{th} = VDD \times \frac{C_{R,A}}{C_{in} + \sum_{i=1}^{N} C_{i,A} + \sum_{i=1}^{N} C_{i,B} + C_{R,A} + C_{R,B}} = \frac{VDD}{4N + 4}$$

If the polarity is negative ($V_{CM} < V_{O-}$), the bit $B_{pre,b}$ is changed from 1'b0 to 1'b1, and $V_{th}$ will be added to Vo+.

3. The first comparator circuit 63 continuously monitors the voltage Vo+ and compares it to the common-mode voltage $V_{CM}$.

If an up-crossing (**$Q_1:0 \rightarrow 1$ while $Q_2=1$**) happens - i.e., when the output of the first comparator circuit 63 switches "up" from a low state to a high state, while the output of the second comparator circuit 64 stays at a high state - the bit $B_{i,a}$ changes from 1'b1 to 1'b0, subtracting the predetermined voltage value $V_{th}$ from the modified first signal Vo+ and adding the predetermined voltage value $V_{th}$ to the modified second signal Vo- respectively.

If a down-crossing (**$Q_1:1 \rightarrow 0$ while $Q_2=0$**) happens - i.e., when the output of the first comparator circuit 63 switches "down" from a high state to a low state, while the output of the second comparator circuit 64 stays at a low state - the bit $B_{i,b}$ changes from 1'b0 to 1'b1, adding the predetermined voltage value $V_{th}$ to the modified first signal $V_{O+}$ and subtracting the predetermined voltage value $V_{th}$ from the modified second signal $V_{O-}$ respectively. The output of the ADC is cumulated by $D_0 = D_0 - 1$.

4. The second comparator circuit 64 monitors the voltage Vo- and compares it to the common-mode voltage $V_{CM}$.

If an up-crossing (**$Q_2:1 \rightarrow 0$**) happens - i.e., when the output of the second comparator circuit 64 switches "down" from a high state to a low state - the bit $B_{pre,a}$ and $B_{pre,b}$ both change from 1'b0 to 1'b1, a value of twice the predetermined voltage value 2x$V_{th}$ will be added to the modified first signal Vo+. The output of the ADC is cumulated by $D_0 = D_0 - 1$.

If a down-crossing (**$Q_2:0 \rightarrow 1$**) happens - i.e., when the output of the second comparator circuit 64 switches "up" from a low state to a high state - the bit $B_{pre,a}$ and $B_{pre,b}$ both change from 1'b1 to 1'b0, a value of twice the

predetermined voltage value $2xV_{th}$ will be subtracted from the modified first signal Vo+. The output of the ADC is cumulated by $D_0 = D_0 + 1$.

5. The steps 2 to 4 will be repeated until a reset is activated or the output of the ADC circuit 60 is overflowed.

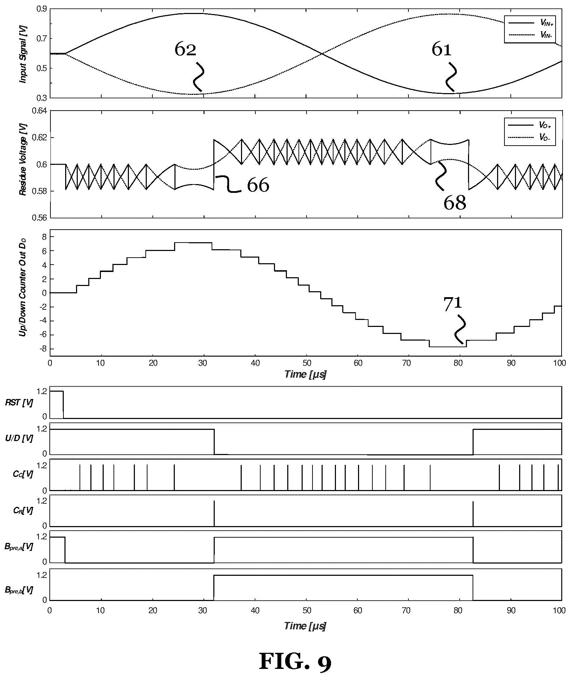

FIG. 9 shows some transient waveforms of the exemplary ADC circuit 60 according to this disclosure. In particular, the upper diagram shows the first and second signal 61, 62, while the second diagram shows the modified signals 66, 68. The output 71 provided by the up-down counter 70 is shown in the next diagram, and the bottom diagram illustrates some internal parameters of the ADC circuit 60.

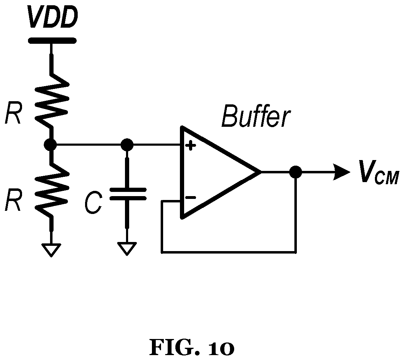

As further shown in FIG. 10, the common-mode voltage $V_{CM}$ can be generated globally with a division ratio of 0.5 from the supply voltage $V_{DD}$ by a resistive divider. Notice that unlike the threshold voltage $V_H$ and $V_L$ in a conventional LC ADC, the common-mode voltage $V_{CM}$ can be shared across recording channels and the ADC circuit 60. The noise of the $V_{CM}$ can be filtered out by a simple RC filter to minimize its impact on the comparator decision.

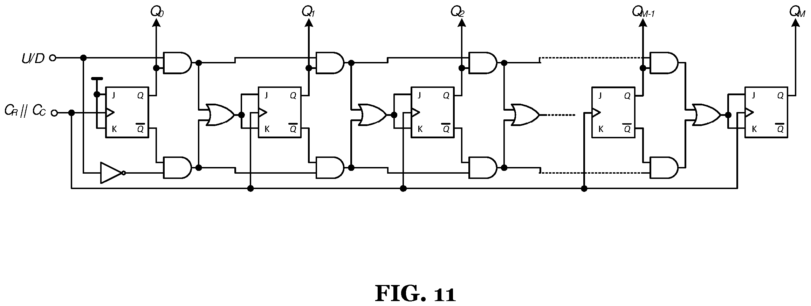

As further shown in FIG. 11, the (M-bit) up-down counter 70 of the ADC circuit 60 can be implemented using multiple JK flip-flops.

FIG. 12 shows a method 100 of operating an ADC circuit 60 according to this disclosure, wherein the ADC circuit 60 comprises a first comparator circuit 63, a second comparator circuit 64, a first switching circuit 65, a second switching circuit 67, and a control circuit 69, as shown in FIG. 6. The first comparator circuit 63 and/or the second comparator circuit 64 may be a comparator circuit 10 as shown in FIG. 1 or FIG. 2, and may accordingly comprise the bump bias circuit 14.

The method 100 comprises a step 101 of receiving a differential input signal, which comprises a first signal and a second signal, e.g., with a general input of the ADC circuit 60. The method 100 may further comprises a step 102 of receiving the first signal 61 with the first switching circuit 65 and providing a modified first signal 66 via a first voltage line from the first switching circuit 65 to a non-inverting input of the first comparator circuit 63, and a step 103 of receiving the second signal 62 with the second switching circuit 65 and providing a modified second signal 68 via a second voltage line from the second switching circuit 67 to an inverting input of the second comparator circuit 63. The method 100 also comprises a step 104 of providing a common mode voltage of the first signal and the second signal to an inverting input of the first comparator circuit 63 and to a non-inverting input of the second comparator circuit 64, respectively. Further, the method 100 comprises a step 105 of setting, by the control circuit 69, at least one capacitor state of first capacitor pairs of the first switching circuit 65 and at least one capacitor state of second capacitors pairs of the second switching circuit 67, based on the outputs of the first comparator circuit 63 and the second comparator circuit 64, which are connected to the control circuit 69. The first and the second capacitor pairs are respectively arranged one after the other along the first voltage line and the second voltage line, and are respectively connected with a common node to the first voltage line and the second voltage line.

In summary of the above, the solutions provided in this disclosure can eliminate the use of the external threshold voltages $V_H$ and $V_L$ as required in a conventional LC ADC. This can be achieved by the ADC circuit 60 using the control circuit 69 to generate the threshold window, hence, avoiding the mismatch between the threshold and feedback value $V_{th}$. Moreover, the bump-based adaptive-bias comparator circuit 10 can efficiently reduce a power consumption compared to the conventional continuous-time comparator. This is, because it consumes power only when the differential input is close to each other.

The solutions of this disclosure can be applied within high-density neural recording systems, particularly for data compression, resulting in a substantial reduction in data throughput requirements for high-density neural probes (e.g., Neuropixels 1.0, 2.0 and NXT).

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

**Claims**

1. An analog to digital converter, ADC, circuit (60) for a neural interface (80), wherein the ADC circuit (60) is configured to receive a differential input signal comprising a first signal (61) and a second signal (62), and wherein the ADC circuit (60) comprises

   a first comparator circuit (63, 10) and a second comparator circuit (64, 10), wherein an inverting input of the first comparator circuit (63, 10) and a non-inverting input of the second comparator circuit (64, 10) are connected to a common mode voltage of the first signal (61) and the second signal (62);

a first switching circuit (65) configured to receive the first signal (61) and to provide a modified first signal (66) via a first voltage line to a non-inverting input of the first comparator circuit (63, 10);
a second switching circuit (67) configured to receive the second signal (62) as an input and to provide a modified second signal (68) via a second voltage line to an inverting input of the second comparator circuit (64, 10); and
a control circuit (69), wherein an output of each comparator circuit (63, 64, 10) is connected as input to the control circuit (69);
wherein the first switching circuit (65) comprises a plurality of first capacitor pairs, and the second switching circuit (67) comprises a plurality of second capacitor pairs, wherein the first and the second capacitor pairs are respectively arranged one after the other along the first voltage line and the second voltage line, and are respectively connected with a common node to the first voltage line and the second voltage line;
wherein the control circuit (69) is configured to set at least one capacitor state of the first capacitor pairs and at least one capacitor state of the second capacitors pairs based on the outputs of the first comparator circuit (63, 10) and the second comparator circuit (64, 10).

2. The ADC circuit (60) according to claim 1, wherein the control circuit (69) is configured to initially set each capacitor state to a default value.

3. The ADC circuit (60) according to claim 1 or 2, wherein the control circuit (69) is configured to
change at least one capacitor state of the first capacitor pairs, such that a predetermined voltage value is subtracted from the modified first signal (66) when the second signal (62) is smaller than the common mode voltage, and such that the predetermined voltage value is added to the modified first signal (68) when the second signal (62) is larger than the common mode voltage.

4. The ADC circuit (60) according to claim 3, wherein

when the output of the first comparator circuit (63, 10) switches "up" from a low state to a high state, while the output of the second comparator circuit (64, 10) stays at a high state, the control circuit (69) is configured to change at least one capacitor state of the first capacitor pairs such that the predetermined voltage value is subtracted from the modified first signal (66), and to change at least one capacitor state of the second capacitor pair such that the predetermined voltage value is added to the modified second signal (68); and
when the output of the first comparator circuit (63, 10) switches "down" from a high state to a low state, while the output of the second comparator circuit (64, 10) stays at a low state, the control circuit (69) is configured to change at least one capacitor state of the first capacitor pairs such that the predetermined voltage value is added to the modified first signal (66), and to change at least one capacitor state of the second capacitor pairs such that the predetermined voltage value is subtracted from the modified second signal (68).

5. The ADC circuit (60) according to claim 3 or 4, wherein

when the output of the second comparator circuit (64, 10) switches "down" from a high state to a low state, the control circuit (69) is configured to change at least one capacitor state of the first capacitor pairs such that twice the predetermined voltage value is added to the modified first signal (66); and
when the output of the second comparator circuit (64, 10) switches "up" from a low state to a high state, the control circuit (69) is configured to change at least one capacitor state of the first capacitor pairs such that twice the predetermined voltage value is subtracted from the modified first signal (66).

6. The ADC circuit (60) according to claim 4 or 5, further comprising
an up-down counter (70), which is configured to receive from the control circuit (69) an output signal and an indication of "up" or "down" switch of a comparator circuit output, and is configured to output a cumulated signal (71) based on the output signal and indication received from the control circuit (69).

7. The ADC circuit (60) according to one of the claims 1 to 6, wherein the first comparator circuit (63, 10) comprises:

a first comparator (63) configured to internally amplify the modified first signal (66) and the common mode voltage, respectively;
a first bump bias circuit (14) configured to receive the amplified modified first signal (66) and the amplified common mode voltage;
wherein the first bump bias circuit (14) is further configured to cause the first comparator (63) to
operate at a higher power level when a difference between the amplified modified first signal (66) and the amplified common mode voltage is smaller, and

operate at a lower power level when the difference between the amplified modified first signal (66) and the amplified common mode voltage is larger.

8. The ADC circuit (60) according to one of the claims 1 to 7, wherein the second comparator circuit (64, 10) comprises:

a second comparator (64) configured to internally amplify the modified second signal (68) and the common mode voltage, respectively;

a second bump bias circuit (14) configured to receive the amplified modified second signal (66) and the amplified common mode voltage;

wherein the second bump bias (14) circuit is further configured to cause the second comparator (64) to

operate at a higher power level when a difference between the amplified modified second signal (68) and the amplified common mode voltage is smaller, and

operate at a lower power level when the difference between the amplified modified second signal (68) and the amplified common mode voltage is larger.

9. The ADC circuit (60) according to claim 7 or 8, wherein the first and/or second bump bias circuit (14) is configured to

provide a larger supply current (21) to respectively the first or second comparator (63, 64) when the difference between respectively the amplified modified first or second signal (66, 68) and the amplified common mode voltage is smaller; and

provide a smaller supply current (21) to respectively the first or second comparator (63, 64) when the difference between respectively the amplified modified first or second signal (66, 68) and the amplified common mode voltage is larger.

10. The ADC circuit (60) according to one of the claims 7 to 9, wherein the first and/or second bump bias circuit (14) is configured to provide a continuously increasing supply current (21) to respectively the first or second comparator (63, 64) when a difference between respectively the amplified modified first or second signal (66, 68) and the amplified common mode voltage continuously decreases.

11. The ADC circuit (60) according to one of the claims 7 to 10, wherein the first and/or second bump bias circuit (14) comprises

a first transistor pair comprising a first transistor ($M_{11}$) a second transistor ($M_{12}$),

a second transistor pair comprising a third transistor ($M_{13}$) and a fourth transistor ($M_{14}$),

wherein a source of the first transistor ($M_{11}$) is connected to a drain of the second transistor ($M_{12}$);

wherein a source of the third transistor ($M_{13}$) is connected to a drain of the fourth transistor ($M_{14}$);

wherein a source of the second transistor ($M_{12}$) and a source of the fourth transistor ($M_{14}$) are connected to ground;

wherein a drain of the first transistor ($M_{11}$) and a drain of the third transistor ($M_{13}$) are connected to a common node (31), to which also a current output transistor ($M_{15}$) is connected;

wherein the amplified modified first or second signal (66, 68), respectively, is connected to a gate of the first transistor ($M_{11}$) and a gate of the fourth transistor ($M_{14}$);

wherein the amplified common mode voltage is connected to a gate of the second transistor ($M_{12}$) and a gate of the third transistor ($M_{13}$); and

wherein the current output transistor ($M_{15}$) is configured to output a larger supply current (21) to respectively the first or second comparator (63, 64) when the difference between respectively the amplified modified first or second signal (66, 68) and the amplified common mode voltage is smaller, and output a smaller supply current (21) to respectively the first or second comparator (63, 64) when the difference between respectively the amplified modified first or second signal (66, 68) and the amplified common mode voltage is larger.

12. The ADC circuit (60) according to claim 11, wherein

a source of the current output transistor ($M_{15}$) is connected to a supply voltage;

a drain of the current output transistor ($M_{15}$) is connected to the common node (31); and

a gate of the current output transistor ($M_{15}$) is connected to the drain of the current output transistor ($M_{15}$) and to respectively the first or second comparator (63, 64).

13. The ADC circuit (60) according to claim 11 or 12, wherein

the gate of the current output transistor ($M_{15}$) is connected to a gate of a current input transistor ($M_{16}$) of respectively the first or second comparator (63, 64);
wherein the current output transistor ($M_{15}$) and the current input transistor ($M_{16}$) form a current mirror.

14. The ADC circuit (60) according to one of the claims 7 to 13, wherein the first and/or second comparator circuit (63, 64) is configured to
perform an auto-zeroing operation to calibrate respectively the first or second bump bias circuit (14), such that the first or second bump bias circuit (14) is configured to cause respectively the first or second comparator (63, 64) to operate at a maximum power level when respectively the amplified modified first or second signal (66, 68) is equal to the amplified common mode voltage.

15. A method (100) of operating an analog to digital converter, ADC, circuit (60) for a neural interface (80), wherein the ADC circuit (60) comprises a first comparator circuit (63, 10), a second comparator circuit (64, 10), a first switching circuit (65), a second switching circuit (67), and a control circuit (69), and wherein the method (100) comprises:

receiving (101) a differential input signal comprising a first signal (61) and a second signal (62);
receiving (102) the first signal (61) with the first switching circuit (65) and providing a modified first signal (66) via a first voltage line to a non-inverting input of the first comparator circuit (63, 10);
receiving (103) the second signal (62) with the second switching circuit (67) and providing a modified second signal (68) via a second voltage line to an inverting input of the second comparator circuit (64, 10);
providing (104) a common mode voltage of the first signal (61) and the second signal (62) to an inverting input of the first comparator circuit (63, 10) and to a non-inverting input of the second comparator circuit (64, 10);
setting (105), by the control circuit (69), at least one capacitor state of first capacitor pairs of the first switching circuit (65) and at least one capacitor state of second capacitor pairs of the second switching circuit (67) based on the outputs of the first comparator circuit (63, 10) and the second comparator circuit (64, 10) connected to the control circuit (69);
wherein the first and the second capacitor pairs are respectively arranged one after the other along the first voltage line and the second voltage line, and are respectively connected with a common node to the first voltage line and the second voltage line.

**FIG. 1**

**FIG. 2**

FIG. 3

FIG. 4

**FIG. 5**

EP 4 730 657 A1

FIG.6

- Main-Switching State Machine

IDEL —RST=1→ **RST phase**
- $B_{1.a}, B_{2.a}, ..., B_{N.a} = 1$
- $B_{1.b}, B_{2.b}, ..., B_{N.b} = 0$
- U/D Counter clear
- $D_o = 0$

RST=0   RST=1

**Down-crossing:**
$D_o--$
$V_{O+}=V_{O+} + V_{th}$
$V_{O-}=V_{O-} - V_{th}$

$Q_1:1\to0$
$C_R=0$
$Q_2 = 0$

**Waiting Phase**

$Q_1:0\to1$
$C_R=0$
$Q_2 = 1$

**Up-crossing:**
$D_o++$
$V_{O+}=V_{O+} - V_{th}$
$V_{O-}=V_{O-} + V_{th}$

- Pre-Switching State Machine

IDEL —RST=1→ **RST phase**
- $B_{pre.a} = 1$
- $B_{pre.b} = 0$

RST=0 & $Q_2 = 0$   RST=0 & $Q_2 = 1$

RST=1   RST=1

**Negative:**
- $V_{O+}=V_{O+} + V_{th}$
- $B_{pre.a} = 1, B_{pre,b} = 1$
- Generate a pulse $C_R$

**Positive:**
- $V_{O+}=V_{O+} - V_{th}$
- $B_{pre.a} = 0, B_{pre,b} = 0$
- Generate a pulse $C_R$

$Q_2 = 1\to 0$   $Q_2 = 0\to 1$

**Up-crossing:**
- $V_{O+}=V_{O+} + 2V_{th}$
- $B_{pre.a} = 1, B_{pre,b} = 1$
- $D_o--$
- Generate a pulse $C_R$

$Q_2 = 0\to1$   $Q_2 = 1\to 0$

**Down-crossing:**
- $V_{O+}=V_{O+} - 2V_{th}$
- $B_{pre.a} = 0, B_{pre,b} = 0$
- $D_o++$
- Generate a pulse $C_R$

RST=1   RST=1

## FIG. 7

**FIG. 8**

FIG. 9

**FIG. 10**

**FIG. 11**

<u>100</u>

```
101 ──  receive a differential input signal comprising a first signal and a second signal

102 ──  receive the first signal with a first switching circuit and provide a modified first
        signal via a first voltage line to a non-inverting input of a first comparator circuit

103 ──  receive the second signal with a second switching circuit and provide a modified
        second signal via a second voltage line to an inverting input of a second
        comparator circuit

104 ──  provide a common mode voltage of the first signal and the second signal to an
        inverting input of the first comparator circuit and to a non-inverting input of the
        second comparator circuit

105 ──  set, with a control circuit, at least one capacitor state of first capacitor pairs of the
        first switching circuit and at least one capacitor state of second capacitor pairs of
        the second switching circuit, based on the outputs of the first comparator circuit
        and the second comparator circuit that are connected to the control circuit
```

**FIG. 12**

**FIG. 13**

**EUROPEAN SEARCH REPORT**

Application Number

EP 24 20 6837

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 608 614 B2 (SONY CORP [JP]; SONY SEMICONDUCTOR SOLUTIONS CORP [JP]) 28 March 2017 (2017-03-28) | 1,2, 7-10,14, 15 | INV. H03M1/12 H03M1/48 |
| A | * column 6, line 63 - column 7, line 2 * * column 9, lines 27-33; figure 7 * | 3-6, 11-13 | H03M1/80 |
| A | US 2003/184927 A1 (AKITA SHIN-ICHI [JP]) 2 October 2003 (2003-10-02) * paragraphs [0043] - [0047], [0063]; figure 17 * | 7-10 | |
| A | US 8 040 271 B2 (TOSHIBA KK [JP]) 18 October 2011 (2011-10-18) * figures 9,10 * | 7-10 | |
| A | YONGJIA LI ET AL: "A 0.5V signal-specific continuous-time level-crossing ADC with charge sharing", BIOMEDICAL CIRCUITS AND SYSTEMS CONFERENCE (BIOCAS), 2011 IEEE, IEEE, 10 November 2011 (2011-11-10), pages 381-384, XP032076604, DOI: 10.1109/BIOCAS.2011.6107807 ISBN: 978-1-4577-1469-6 * abstract; figures 3a,4a * | 1-15 | |
| A | US 11 750 206 B2 (STICHTING IMEC NEDERLAND [NL]) 5 September 2023 (2023-09-05) * abstract; figure 2 * | 1-15 | |

TECHNICAL FIELDS SEARCHED (IPC)

H03M

The present search report has been drawn up for all claims

| Place of search | Date of completion of the search | Examiner |
|---|---|---|
| The Hague | 11 March 2025 | Galardi, Leonardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 6837

This annex lists the patent family members relating to the patent documents cited in the above-mentioned European search report.
The members are as contained in the European Patent Office EDP file on
The European Patent Office is in no way liable for these particulars which are merely given for the purpose of information.

11-03-2025

| Patent document cited in search report | | Publication date | Patent family member(s) | | Publication date |
|---|---|---|---|---|---|
| US 9608614 | B2 | 28-03-2017 | CN | 104753505 A | 01-07-2015 |
| | | | CN | 110022139 A | 16-07-2019 |
| | | | JP | 6180318 B2 | 16-08-2017 |
| | | | JP | 2015126454 A | 06-07-2015 |
| | | | US | 2015187335 A1 | 02-07-2015 |
| | | | US | 2017163253 A1 | 08-06-2017 |
| US 2003184927 | A1 | 02-10-2003 | JP | 2002311063 A | 23-10-2002 |
| | | | US | 2003184927 A1 | 02-10-2003 |
| US 8040271 | B2 | 18-10-2011 | JP | 5175700 B2 | 03-04-2013 |
| | | | JP | 2010136162 A | 17-06-2010 |
| | | | US | 2010142653 A1 | 10-06-2010 |
| US 11750206 | B2 | 05-09-2023 | EP | 4024713 A1 | 06-07-2022 |
| | | | US | 2022216879 A1 | 07-07-2022 |

EPO FORM P0459

For more details about this annex : see Official Journal of the European Patent Office, No. 12/82